# EUROPEAN PATENT APPLICATION

(11) **EP 2 911 182 A1**
(43) Date of publication of application: **26.08.2015**
(21) Application number: 15154765.0
(22) Date of filing: 11.02.2015
(51) Int. Cl.: H01J 41/18, H01J 41/20

(54) **Thin film edge field emitter based micro ion pump**

(30) Priority: 24.02.2014 US 201461943778 P; 14.05.2014 US 201414277309
(71) Applicant: Honeywell International Inc., Morristown, NJ 07962-2245 (US)
(72) Inventor: Tin, Steven, Morristown, NJ 07962-2245 (US)
(74) Representative: Houghton, Mark Phillip

(57) **Abstract**

A micro-ion pump is provided. The micro-ion pump includes a plurality of thin-film-edge field emitters, a first gate electrode, a second gate electrode, and a high voltage anode. The plurality of thin-film-edge field emitters is in a first X-Z plane. The plurality of thin-film-edge field emitters has a respective plurality of end faces with a high aspect ratio in at least one Y-Z plane. The first gate electrode is in a second X-Z plane offset from the first X-Z plane. The second gate electrode is positioned in a third X-Z plane offset from the first X-Z plane. The high voltage anode is in a fourth X-Z plane offset from the plurality of thin-film-edge field emitters in the first X-Z plane. The second gate electrode is between the high voltage anode and the plurality of thin-film-edge field emitters.

## Description

This patent application claims priority to United States Provisional Patent Application No. 61/943,778, entitled "THIN FILM EDGE FIELD EMITTER BASED MICRO ION PUMP" filed February 24, 2014, which is hereby fully incorporated herein by reference.

### BACKGROUND

While cold atom timing and navigation references provide extreme accuracies, they require high vacuum (~ 10-8 Torr) to operate. With continuing efforts to miniaturize cold atom technology, such as DARPA's Integrated Micro primary Atomic Clock Technology (IMPACT) and Chip-Scale Combinatorial Atomic Navigator (CSCAN), micro-sized vacuum technology development is also required to enable device portability. Due to constraints on size, power, lifetime, and magnetic field strength for cold atom and other high vacuum micro-electro-mechanical system (MEMS) applications, there is no micro vacuum technology currently available that meets all the requirements.

### SUMMARY

A micro-ion pump is provided. The micro-ion pump includes a plurality of thin-film-edge field emitters, a first gate electrode, a second gate electrode, and a high voltage anode. The plurality of thin-film-edge field emitters is in a first X-Z plane. The plurality of thin-film-edge field emitters has a respective plurality of end faces with a high aspect ratio in at least one Y-Z plane. The first gate electrode is in a second X-Z plane offset from the first X-Z plane. The second gate electrode is positioned in a third X-Z plane offset from the first X-Z plane. The high voltage anode is in a fourth X-Z plane offset from the plurality of thin-film-edge field emitters in the first X-Z plane. The second gate electrode is between the high voltage anode and the plurality of thin-film-edge field emitters.

### DRAWINGS

Understanding that the drawings depict only exemplary embodiments and are not therefore to be considered limiting in scope, the exemplary embodiments will be described with additional specificity and detail through the use of the accompanying drawings, in which:
Figure 1 is a first side cross-sectional view of an embodiment of a thin-film-edge field emitter based micro-ion pump;
Figure 2 is second side cross-sectional view of the thin-film-edge field emitter based micro-ion pump of Figure 1;
Figure 3 is top view of a portion of the thin-film-edge field emitter based micro-ion pump of Figure 1;
Figure 4 is top view of a portion of an embodiment of a thin-film-edge field emitter based micro-ion pump;
Figure 5 is top view of a portion of a system including a thin-film-edge field emitter based micro-ion pump enclosed in a housing; and
Figure 6 is a flow diagram for an exemplary method for forming a micro-ion pump.

In accordance with common practice, the various described features are not drawn to scale but are drawn to emphasize specific features relevant to the exemplary embodiments. Reference characters denote like elements throughout figures and text.

### DETAILED DESCRIPTION

In the following detailed description, reference is made to the accompanying drawings that form a part hereof, and in which is shown by way of illustration specific illustrative embodiments. However, it is to be understood that other embodiments may be utilized and that structural, mechanical, and electrical changes may be made. Furthermore, the method presented in the drawing figures and the specification is not to be construed as limiting the order in which the individual steps may be performed. The following detailed description is, therefore, not to be taken in a limiting sense.

In order to overcome the above referenced problems, a new micro vacuum pump technology is required for the final success of the miniature cold atom technologies. The embodiments of micro-ion pump described herein have several important advantages. The embodiments of micro-ion pump described herein have a small size of less than 1cc in volume. This is 70 times less than the smallest commercially available ion pumps, which are greater 70 cc in volume. Unlike currently available ion pumps, no magnetic field is required to operate the embodiments of micro-ion pump described herein. This is an advantage since the magnetic fields degrade the performance of the devices in which the micro-ion pump is used. For example, for a cold atom device in which a micro-ion pump is required, the magnetic fields degrade the performance of the cold atom device. The edges of the emitters of the micro-ion pumps described herein are relatively large (with reference to traditional micro tips used in micro-ion pumps) and are less liable to be damaged. Specifically, the edge emitter described herein, has an emitting area that is larger than a tip, and hence is less likely to suffer from cathode degradation by fields forming at high current densities. Additionally, the emitter edge of the micro-ion pump is protected from high energy ions by the upper gate electrode. Damage from high energy ions is considered to be the major cause of failure for micro tip field emitters.

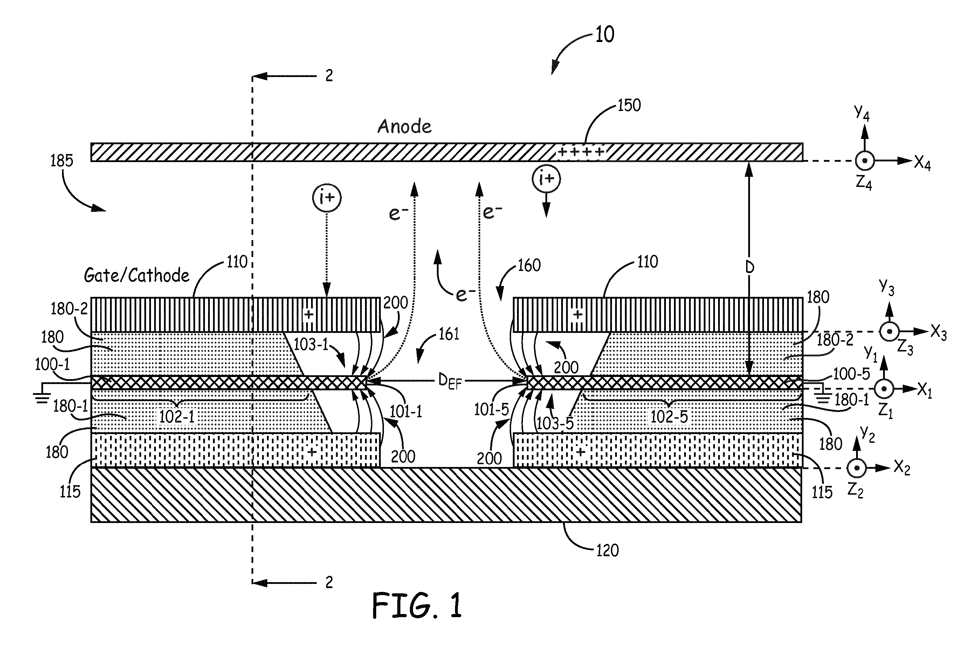

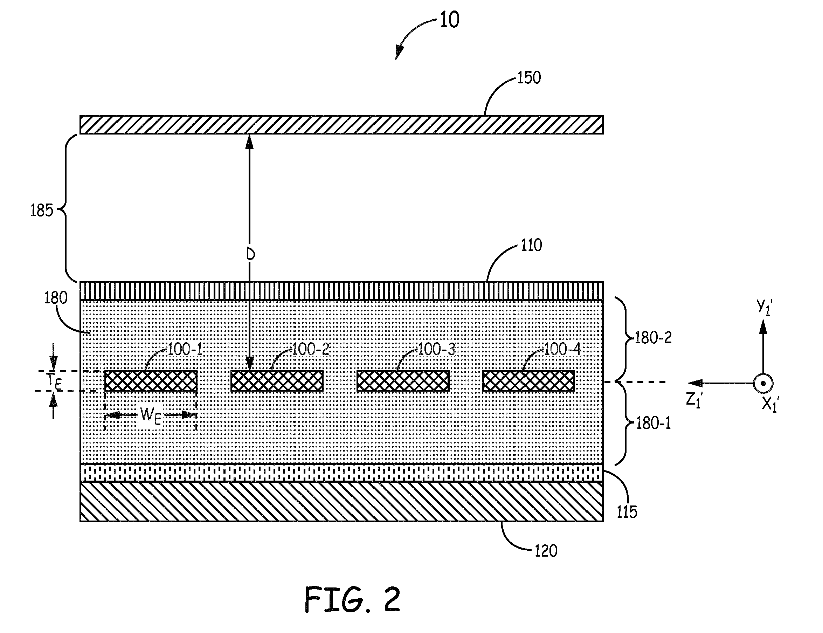

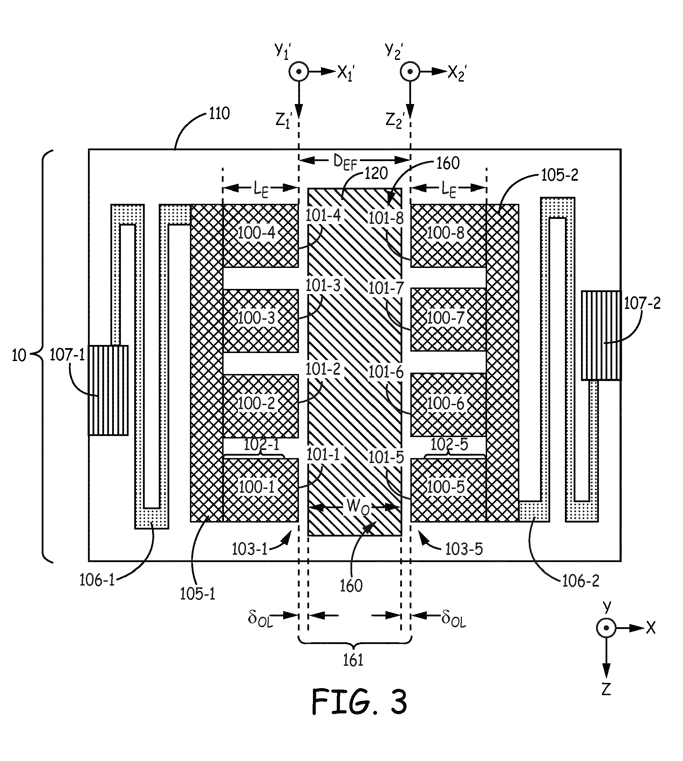

Figure 1 is a first side cross-sectional view of an embodiment of a thin-film-edge field emitter based micro-ion pump 10. Figure 2 is second side cross-sectional view of the thin-film-edge field emitter based micro-ion pump 10 of Figure 1. The plane upon which the cross-section view of Figure 2 is taken is indicated by section line 2-2 in Figure 1. Figure 3 is top view of a portion of the thin-film-edge field emitter based micro-ion pump 10 of Figure 1. Specifically, Figure 3 shows an opening 160 in a second gate electrode 110 superimposed over a plane (X-Z) in which thin-film-edge field emitters 100(1-8), back-connectors 105(1-2), emitter resistors 106(1-2), and contact pads 107(1-2) are positioned. The thin-film-edge field emitter based micro-ion pump 10 is also referred to herein as "micro-ion pump 10".

The thin-film-edge field emitter based micro-ion pump 10 includes a plurality of thin-film-edge field emitters 100(1-8) (Figure 3), a first gate electrode 115, a second gate electrode 110, and a high voltage anode 150. The thin-film-edge field emitters 100(1-8) are also referred to herein as "high aspect ratio edge emitters 100(1-8)" or "emitters 100(1-8)". An i^{th} one of the thin-film-edge field emitters 100(1-8) is referred to herein as emitter 100-i, where i is a positive integer.

The thin-film-edge field emitters 100(1-4) are in a first X-Z plane (X₁, Z₁) (Figure 1) and have a respective plurality of end faces 101(1-4) with a high aspect ratio in a first Y-Z plane (Y'₁, Z'₁) (Figures 2 and 3). The thin-film-edge field emitters 100(5-8) are in the first X-Z plane (X₁, Z₁) (Figure 1), which is also shown as X-Z plane (X'₂, Z'₂) in Figure 3. The thin-film-edge field emitters 100(5-8) have a respective plurality of end faces 101(5-8) with a high aspect ratio in a second Y-Z plane (Y'₂, Z'₂) (Figure 3). The endfaces 101(1-8) are the edges of the thin-film-edge field emitters 100(1-8) from which electrons e⁻ are emitted.

The first gate electrode 115 is in a second X-Z plane (X₂, Z₂) (Figure1) that is offset from the first X-Z plane (X₁, Z₁). The second gate electrode 110 is in a third X-Z plane (X₃, Z₃) (Figure1) that is offset from the first X-Z plane (X₁, Z₁). The first gate electrode 115 is also referred to herein as a "lower gate electrode 115". The second gate electrode 110 is also referred to herein as an "upper gate electrode 110" or "cathode 110".

The high voltage anode 150 is in a fourth X-Z plane (X₄, Z₄) (Figure1) that is offset from the plurality of thin-film-edge field emitters 100(1-8) in the first X-Z plane (X₁, Z₁) by a distance D (Figure 1 and 2). The second gate electrode 110 is between the high voltage anode 150 and the plurality of thin-film-edge field emitters 100(1-8). Thus, the third X-Z plane (X₃, Z₃) is parallel to and between the first X-Z plane (X₁, Z₁) and the fourth X-Z plane (X₄, Z₄).

The lower gate electrode 115 is separated from the emitters 100(1-8) by a first portion 180-1 of an insulator layer 180. The upper gate electrode 110 separated from the emitters 100(1-8) by a second portion 180-2 of the insulator layer 180. The upper gate electrode 110 is offset from the high voltage anode 150 by a gap 185. As defined herein, the gap 185 does not include an insulating material other than air. When the micro-ion pump 10 is operational in an enclosure, air in the gap 185 is considered to include any molecules of gas remaining in the vacuum. Once the micro-ion pump 10 has achieved a vacuum, there is a vacuum in the gap 185. The terms "gap 185" and "vacuum gap 185" are used interchangeably herein.

As shown in Figures 1 and 3, the thin-film-edge field emitter 100-1 includes a body portion represented generally at 102-1 and an end face portion represented generally at 103-1. The end face portion 103-1 includes a high aspect ratio end face 101-1 (Figure 2). Likewise, as shown in Figures 1 and 3, the thin-film-edge field emitter 100-5 includes a body portion 102-5 and an end face portion 103-5. The end face portion 103-5 includes a high aspect ratio end face 101-5. The other thin-film-edge field emitters 100(2-4) and 100(6-8) are similarly configured. As shown in Figure 2, the high aspect ratio end faces 101(1-4) are rectangular in shape although other elongated shapes are possible.

The main bodies 102(1-8) of the respective thin-film-edge field emitters 100(1-8) in the first X-Z plane (X₁, Z₁) are encased by the first portion 180-1 and the second portion 180-2 of the insulating layer 180-1. The end face portions 103(1-8) extend from the first portion 180-1 and the second portion 180-2 of the insulating layer 180-1. As shown in Figures 1 and 3, the high aspect ratio end faces 101(1-4) are separated by a gap represented generally at 161 of a distance D_{EF} from the opposing high aspect ratio end faces 101 (5-8). The gap 161 between the opposing high aspect ratio end faces 101(1-4) and high aspect ratio end faces 101(5-8) is not filled with any insulating material. Once the micro-ion pump 10 has achieved a vacuum, there is a vacuum in the gap 161. The terms "gap 161" and "vacuum gap 161" are used interchangeably herein.

The second gate electrode 110 is a metal layer with a rectangular opening 160 (Figures 1 and 3). The opening 160 has a width Wₒ (Figure 3) in the X direction that is less than the distance D_{EF} between the first Y-Z plane (Y'₁, Z'₁) and the second Y-Z plane (Y'₂, Z'₂) (Figure 3) so the end face portions 103(1-8) are protected from the high voltage anode 150 by the second gate electrode 110.

As shown in Figure 3, the distance D_{EF} between the end faces 101(1-4) and the opposing end faces 101 (5-8) is greater than the width Wₒ of the opening 160 in the second gate electrode 110 by twice the length δ_{OL}. The portion of the second gate electrode 110 that protrudes over the high aspect ratio first end faces 101(1-4) by the length δ_{OL} provides protection to the respective end faces 101(1-4) from high energy gas ions represented generally at i⁺. Likewise, the portion of the second gate electrode 110 that protrudes over the high aspect second end faces 101(5-8) by the length δ_{OL} provides protection to the respective end faces 101(5-8) from high energy gas ions i⁺. The high energy gas ions i⁺ are ionized by the electrons e⁻ emitted by emitters 100(1-8) and accelerated by field between anode 150 and upper gate electrode 110.

The prior art micro-ion pumps use tip emitters, which come to a point and which are not protected by a gate. Therefore, the gas ions bombard the pointed tip emitters and damage them, which significantly reduces the lifetime of the prior art micro-ion pumps. The embodiments of micro-ion pumps described herein are designed to have prolonged lifetimes for two reasons. First, the end face portions 103(1-8) of the thin-film-edge field emitters 100(1-8) are shielded from the gas ions. Second, the high aspect ratio of the end faces 101(1-8) of the thin-film-edge field emitters 100(1-8) are less susceptible to damage than emitters that end in a sharp point.

As shown in Figure 3, the high aspect ratio edge emitters 100(1-4) are electrically connected to each other by a back-connector 105-1. The high aspect ratio edge emitters 100(1-4) are referred to herein as "a first portion 100(1-4) of a plurality of high aspect ratio edge emitters 100(1-8)". The back-connector 105-1 is connected by emitter resistor 106-1 to a contact pad 107-1. Likewise, the high aspect ratio edge emitters 100(5-8) are electrically connected to each other by a back-connector 105-2. The high aspect ratio edge emitters 100(5-8) are referred to herein as "a second portion 100(5-8) of a plurality of high aspect ratio edge emitters 100(1-8)". The back-connector 105-2 is connected by emitter resistor 106-2 to a contact pad 107-2.

As shown in Figure 2, the emitters 100(1-8) have a thickness T_{E} and a width W_{E}. As shown in Figure 3, the emitters 100(1-8) have a length L_{E}. The width W_{E} has an extent in the Z' direction of the Y'-Z' plane, the thickness T_{E} has an extent in the Y' direction of the Y'-Z' plane, and the length L_{E} has an extent in the X' direction of the X'-Z' plane. The thickness T_{F} of the emitters 100(1-8) is much less than the length L_{E} and width W_{E} of the emitters 100(1-8).

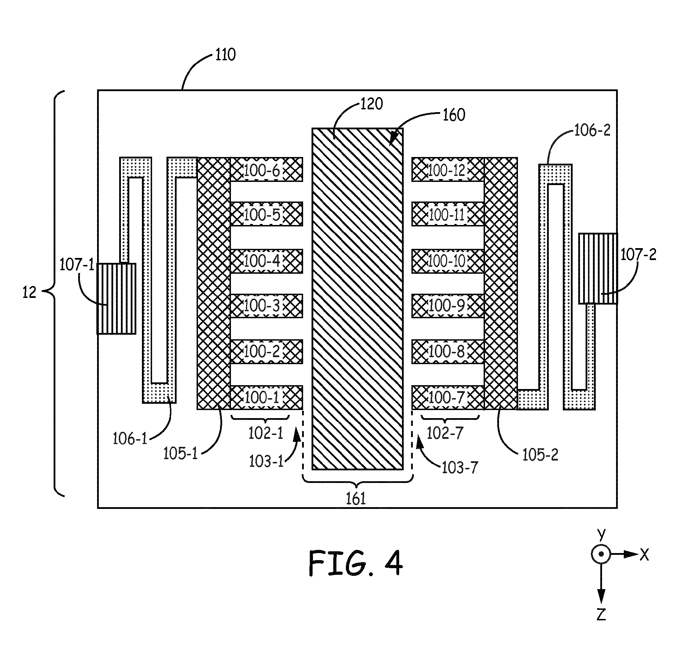

Other embodiments of the micro-ion pump include a different number of thin-film-edge field emitters, which can have the same or different shapes as shown in Figure 4. Figure 4 is top view of a portion of an embodiment of a thin-film-edge field emitter based micro-ion pump 12. The micro-ion pump 12 differs from the micro-ion pump 10 in that the shape of the emitters is different. As shown in Figure 4, the width W_{E} of the emitters 100(1-12) shown in Figure 4 are narrower (in the Z direction) than the width W_{F} of the emitters 100(1-8) of Figures 2 and 3.

In one implementation of this embodiment, the width W_{E} is at least 10 times the thickness T_{E}. In another implementation of this embodiment, the length L_{E} is on the order of a few microns, the width W_{E} is on the order of a few to tens of microns, and the thickness T_{E} is on the order of a tens of nanometers. In yet another implementation of this embodiment, the width W_{E} is within a range of two to twenty microns and the thickness T_{E} is within a range of ten nanometers to thirty nanometers. In yet another implementation of this embodiment, the thickness T_{E} of the high aspect ratio edge emitters 100(1-8) is 20 nm thick. In yet another implementation of this embodiment, the high aspect ratio edge emitters 100(1-8) are formed from a layer of platinum.

The operation of the micro-ion pump is now described. When the micro-ion pump 10 is operational, the high voltage anode 150 is positively charged at a high voltage (e.g., on the order of kilovolts), the first gate electrode 115 and the second gate electrode 110 are positively charged at lower voltages (e.g., at less than 100 Volts), and the thin-film-edge field emitters 100(1-8) are grounded. In this manner, the high voltage anode 150 at a higher potential then any of the first gate electrode 115, the second gate electrode 110, and the thin-film-edge field emitters 100(1-8). The first gate electrode 115 and the second gate electrode 110 are at a higher potential than the thin-film-edge field emitters 100(1-8).

When a voltage (< 100V) is applied to the upper gate electrode 110 and the lower gate electrode 115, an ultra-high electric field represented generally at 200 is formed at the end faces 101-1 and 101-5 of the emitters 100-1 and 100-5, respectively, (Figure 1) due to the high aspect ratio of the end faces 101-1 and 101-5 of the emitters 100-1 and 100-5. As shown in Figure 1, electrons e⁻ are emitted from end faces 101-1 and 101-5 of the emitters 100-1 and 100-5 due to the high electric field 200. Emitted electrons e⁻ are accelerated toward the anode 150 through the opening 160 and the gap 185 as indicated by the dash/curved arrow. The accelerated electrons e⁻ bombard and ionize residue gas molecules in the gap 185. The ionized gas molecules i⁺ are accelerated towards the second gate electrode 110 due to electrical field between anode 150 and the second gate electrode 110. The ionized gas molecules i⁺ are also referred to herein as "ions i⁺".

The end faces 101-*i* and end face portions 103-*i* of the respective emitters 100-i are not exposed to the ions i⁺ that are accelerated away from anode 150 since the end faces 101(1-8) are covered by the upper gate electrode 110. Thus, the end faces 101-i and end face portions 103-*i* of the respective emitters 100-i are not degraded during operation of the micro-ion pump 10 by the ions i⁺. The fact that the W_{E} >> T_{E} (i.e., the edge emitters 100(1-4) have a high aspect ratio) is another reason the end faces 101-i and end face portions 103-*i* of the respective emitters 100-i are not degraded during operation of the micro-ion pump 10.

In one implementation of this embodiment, the high voltage anode 150 is between 2 kilovolts and 3 kilovolts. In another implementation of this embodiment, the high voltage anode 150 is offset from the thin-film-edge field emitter 100(1-8) by the distance D (Figure 1) within the range of 6 millimeters to 10 millimeters.

An ion pump is capable of reaching very low pressures (e.g., approaching 10⁻¹¹ mbar). To reduce the pressure inside a vacuum (i.e., pumping), gas molecules must be removed from the enclosed space. In one implementation of this embodiment, the enclosed space is formed by a housing for the micro-ion pump 10. There are two mechanisms to remove gas molecules, which both happen simultaneously. The first mechanism operates on noble gases. When the noble gas ions i⁺ bombarded into cathode 110, a portion of the noble gas ions i⁺ are neutralized, and reflected away from the cathode 110. These reflected the noble gas ions i⁺ penetrate into the 150 anode or the pump walls (e.g., the walls enclosing the micro-ion pump). During the ion collision process, some cathode materials are sputtered away. The sputtered cathode material coats the anode 150 and the pump wall, thereby burying the neutralized ion that penetrated into the wall/anode in the process. This is the primary pumping mechanism for noble gases.

The second mechanism operates on chemically active gases (i.e., O₂, CO₂, etc., as known to one skilled in the art). The first mechanism also operates on the chemically active gases, but it is not the primary pumping mechanism for chemically active gases. In one implementation of this embodiment, the second gate electrode (cathode) 110 is formed from a chemically active material. When the chemically active material of the cathode 110 is sputtered away, it coats the anode 150 and pump wall surface as mentioned above. The chemically active gas molecules are chemically attached to the coated surface and the molecules are coated over and buried with the chemically active material of the cathode 110. For example, a chemically active material in the cathode 110 is sputtered away from the cathode 110 to bury implanted neutral molecules and to absorb chemically active gas molecules.

In another implementation of this embodiment, the second gate electrode 110 is formed from Tantalum. Tantalum advantageously has a high atomic weight, which increases the probability of gas ions i⁺ being reflected with high energy to penetrate into the anode 150 and/or the pump wall. This high energy increases noble gas pumping rate. In yet another implementation of this embodiment, the second gate electrode 110 is formed from Titanium. In yet another implementation of this embodiment, the second gate electrode 110 is formed from a combination of Tantalum and Titanium. In yet another implementation of this embodiment, the second gate electrode 110 is formed from a non-chemically active material that can be sputtered. In summary, to pump noble gases, the second gate electrode 110 does not need to be chemically active, as long as it can be sputtered. In order to pump chemically active gases (gases other than noble gases), the second gate electrode 110 needs to be chemically active to have a high pumping speed.

In yet another implementation of this embodiment, the anode 150 is formed from stainless steel. In yet another implementation of this embodiment, the insulator layers 180-1 and 180-2 are formed from silicon nitride and/or silicon oxide. In yet another implementation of this embodiment, the emitter resistors 106-1 and 106-2 are formed from TaN. In yet another implementation of this embodiment, the substrate 120 is a silicon substrate 120. Other dimensions and materials can be used to form the micro-ion pump 10.

The micro-ion pump 10 or 12 as shown herein is capable of achieving a very high vacuum on the order of (~ 10-8 Torr) without performance degradation over an extended period of time.

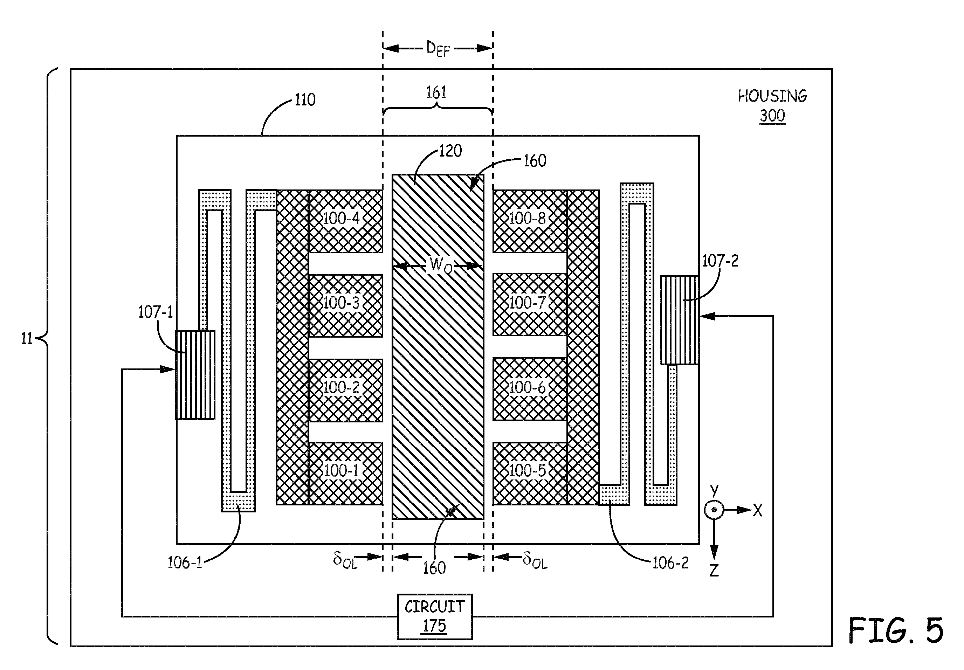

Figure 5 is top view of a portion of a high-vacuum-micro-electro-mechanical system (MEMS) 11 including a thin-film-edge field emitter based micro-ion pump 10 as shown in Figures 1-3. Embodiments of the micro-ion pump 12 described herein can be used in the high-vacuum-MEMS 11 when positioned in a housing 300. The housing 300 is designed, as appropriate, for the technology in which the micro-ion pump 10 is being used. In one implementation of this embodiment, the walls of the housing 300 are the pump walls. As shown in Figure 5, an exemplary circuit 175 is in the housing 300. The circuit 175 is connected to the micro-ion pump 10 to apply the voltages required for the micro-ion pump 10 to reduce the pressure in the housing 300. The circuit 175 is configured to operably apply a voltage potential difference between the high voltage anode 150 and the lower gate electrode 115, the upper gate electrode 110, and the plurality of thin-film-edge field emitters 100(1-8). In another implementation of this embodiment, the circuit 175 is external to the housing 300. In yet another implementation of this embodiment, an additional enclosure is in the housing 300 separating the circuit 175 from the micro-ion pump 10. In this latter case, the internal enclosure includes the walls onto which the cathode material is sputtered.

In one implementation of this embodiment, a miniature cold atom system 11 is made using a housing 300 to enclose a micro-ion pump 10. The embodiments of micro-ion pumps for use in the miniature cold atom system 11 include: a plurality of thin-film-edge field emitters 100(1-8) in a first X-Z plane having a respective plurality of main bodies 102(1-8) encased by an insulating layer 180 while a respective plurality of high aspect ratio end faces 101(1-8) and end face portions 103(1-8) extend from the insulating layer 180; a first gate electrode 115 in a second X-Z plane offset from the first X-Z plane by a first portion 180-1 of the insulating layer 180; a second gate electrode 110 in a second X-Z plane offset from the first X-Z plane by a second portion 180-2 of the insulating layer 180; and a high voltage anode 150 offset from the plurality of thin-film-edge field emitters 100(1-8) by a distance D. The second gate electrode 110 is between the high voltage anode 150 and the plurality of thin-film-edge field emitters 100(1-8).

In another implementation of this embodiment, other high-vacuum-MEMS systems for other applications are made using the appropriately designed housing to enclose a micro-ion pump described herein.

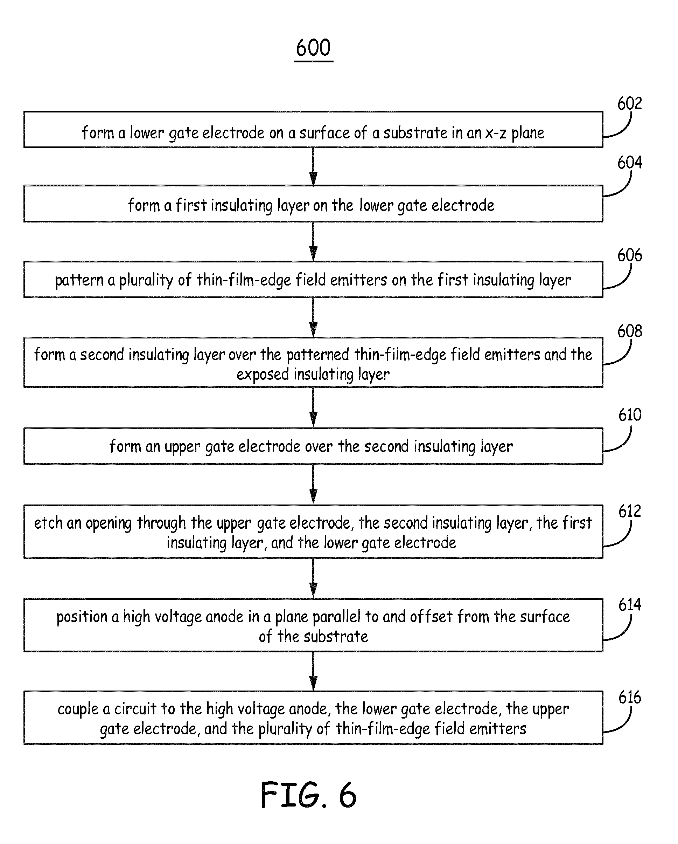

Figure 6 is a flow diagram for an exemplary method for forming a micro-ion pump. Method 600 is applicable to any of the embodiments of micro-ion pumps described herein. The micro-ion pumps are formed as a MEMS device for use in MEMS systems.

At block 602, a lower gate electrode is formed on a surface of a substrate in an X-Z plane. The lower gate electrode 115 can be formed from a metal from one of a variety of known techniques for depositing conductive materials, including, but not limited to, metal sputtering or metal plating. In one implementation of this embodiment, the lower gate electrode 115 is formed from a layer of Tantalum.

At block 604, a first insulating layer is formed on the lower gate electrode. The first insulating layer 180-1 can be formed by one of a variety of known techniques for depositing insulating materials. In one implementation of this embodiment, the first insulating layer 180-1 is formed from silicon nitride and/or silicon oxide.

At block 606, a plurality of thin-film-edge field emitters are patterned on the first insulating layer. In one implementation of this embodiment, first end faces 101(1-4) of a first portion 100(1-4) of the plurality of thin-film-edge field emitters 100(1-8) are in a first Y-Z plane, and second end faces 101 (5-8) of a second portion 100(5-8) of the plurality of thin-film-edge field emitters 100(1-8) are in a second Y-Z plane. Also, at block 606, the circuits to apply appropriate voltages to the electrodes are patterned on the first insulating layer. In one implementation of this embodiment, a first back-connector 105-1 is patterned in contact with the first portion 100(1-4) of the plurality of thin-film-edge field emitters 100(1-8), a second back-connector 105-2 is patterned in contact with the second portion 100(5-8) of the plurality of thin-film-edge field emitters 100(1-8), a first emitter resistor 106-1 is patterned in contact with the first back connector 105-1 and a second emitter resistor 106-2 is patterned in contact with the second back connector 105-2. In another implementation of this embodiment, a first contact pad 107-1 is patterned in contact with the first emitter resistor 106-1 and a second contact pad 107-2 is patterned in contact with the second emitter resistor 106-2.

At block 608, a second insulating layer is formed over the patterned thin-film-edge field emitters and the exposed first insulating layer. The second insulating layer 180-2 can be formed by from one of a variety of known techniques for depositing insulating materials. If the first back-connector 105-1, the second back-connector 105-2, the first emitter resistor 106-1, and the second emitter resistor 106-2 were patterned on the first insulating layer 180-1 at block 606, the second insulating layer 180-2 is also formed over the first back-connector 105-1, the second back-connector 105-2, the first emitter resistor 106-1, the second emitter resistor 106-2, any exposed first insulating layer 180-1, and the thin-film-edge field emitters 100(1-8).

In one implementation of this embodiment, if the first contact pad 107-1 and the second contact pad 107-2 were patterned in contact with the respective first emitter resistor 106-2 and the second emitter resistor 106-2 at block 606, the second insulating layer 180-2 is not formed over the first contact pad 107-1 and the second contact pad 107-2. In another implementation of this embodiment, if the first contact pad 107-1 and the second contact pad 107-2 were patterned in contact with the respective first emitter resistor 106-2 and the second emitter resistor 106-2 at block 606, the second insulating layer 180-2 is formed over the first contact pad 107-1 and the second contact pad 107-2. In this case, an opening is later formed through the second insulating layer 180-2 in order to provide electrical contact for circuits required to apply the appropriate voltages to the thin-film-edge field emitters 100(1-8).

At block 610, an upper gate electrode is formed over the second insulating layer. The upper gate electrode 110 (i.e., cathode 110) can be formed from a metal from one of a variety of known techniques for depositing conductive materials as described above with reference to block 602.

At block 612, an opening is etched through the upper gate electrode, the second insulating layer, the first insulating layer, and the lower gate electrode. The cavity formed by etching the opening 160 and the gap 161 (Figure 1) is such that the first end faces 101(1-4) extend from the first portion 180-1 and the second portion 180-2 of the insulating layer 180 and the second end faces 101(5-8) also extend from the first portion 180-1 and the second portion 180-2 of the insulating layer 180. The opening 190 in the upper gate electrode 110 has a width Wₒ in the X direction that is less than the distance D_{EF} between the first Y-Z plane (Y'1, Z'₁) and the second Y-Z plane (Y'₂, Z'₂) (Figure 3).

The thin film edge field emitters in the thin-film-edge field emitter based micro-ion pumps described herein can be fabricated by conventional thin film deposition, photo-lithography patterning, and etching processing techniques.

At block 614, a high voltage anode 150 is positioned in a plane parallel to and offset from the surface of the substrate 120 so that the upper gate electrode 110 is between the plurality of thin-film-edge field emitters 100(1-8) and the high voltage anode 150.

At block 616, a circuit 175 is coupled to the high voltage anode 150, the lower gate electrode 115, the upper gate electrode 110, and the plurality of thin-film-edge field emitters 100(1-8). The circuit 175 is configurable to operably apply a voltage potential difference between the high voltage anode 150 and the lower gate electrode 115, the upper gate electrode 110, and the plurality of thin-film-edge field emitters 100(1-8) as described above.

In one implementation of this embodiment, the thin-film-edge field emitter based micro-ion pump is integrated into a miniature cold atom time and navigation references. Due to the robustness of the thin-film-edge field emitter based micro-ion pumps described herein, the miniature cold atom time and navigation references are expected to operate for more than 10 years. Since the thin-film-edge field emitter based micro-ion pumps described herein are less than 1 cubic centimeter in volume, they are able to fit inside the cold atom chamber for continuous pumping.

### Example Embodiments

Example 1 includes a micro-ion pump, comprising: a plurality of thin-film-edge field emitters in a first X-Z plane, wherein the plurality of thin-film-edge field emitters have a respective plurality of end faces with a high aspect ratio in at least one Y-Z plane; a first gate electrode in a second X-Z plane offset from the first X-Z plane; a second gate electrode positioned in a third X-Z plane offset from the first X-Z plane; and a high voltage anode in a fourth X-Z plane offset from the plurality of thin-film-edge field emitters in the first X-Z plane, wherein the second gate electrode is between the high voltage anode and the plurality of thin-film-edge field emitters.

Example 2 includes the micro-ion pump of Example 1, further comprising an insulating layer, the insulating layer including a first portion and a second portion, wherein the first gate electrode in the second X-Z plane is offset from the plurality of thin-film-edge field emitters in the first X-Z plane by the first portion of the insulating layer, and wherein the second gate electrode in the third X-Z plane is offset from the plurality of thin-film-edge field emitters in the first X-Z plane by the second portion of the insulating layer, wherein a plurality of main bodies of the respective plurality of thin-film-edge field emitters in the first X-Z plane is encased by the first portion and the second portion of the insulating layer while the plurality of high aspect ratio end faces of the plurality of thin-film-edge field emitters extend from the first portion and the second portion of the insulating layer.

Example 3 includes the micro-ion pump of Example 2, wherein the plurality of thin-film-edge field emitters include: a first portion of the plurality of thin-film-edge field emitters having a plurality of first end faces in a first Y-Z plane, and a second portion of the plurality of thin-film-edge field emitters having a plurality of second end faces in a second Y-Z plane, wherein an opening in the second gate electrode has a width in the X direction that is less than the difference between the first Y-Z plane and the second Y-Z plane, wherein the plurality of high aspect ratio first end faces and the plurality of high aspect second end faces are protected from high energy ions by the second gate electrode.

Example 4 includes the micro-ion pump of any of Examples 1-3, wherein the second gate electrode is formed from a chemically active material.

Example 5 includes the micro-ion pump of any of Examples 1-4, the second gate electrode is formed from at least one of: Tantalum and Titanium.

Example 6 includes the micro-ion pump of any of Examples 1-5, further comprising: a back-connector in electrical contact with at least two of the plurality of thin-film-edge field emitters; and an emitter resistor in electrical contact with the back-connector.

Example 7 includes the micro-ion pump of Example 6, further comprising a contact pad in electrical contact with the emitter resistor.

Example 8 includes the micro-ion pump of any of Examples 1-7, further comprising: a first back-connector in electrical contact with a first portion of the plurality of thin-film-edge field emitters; a first emitter resistor in electrical contact with the first back-connector; a second back-connector in electrical contact with a second portion of the plurality of thin-film-edge field emitters; and a second emitter resistor in electrical contact with the second back-connector.

Example 9 includes the micro-ion pump of Example 8, further comprising; a first contact pad in electrical contact with the first emitter resistor; and a second contact pad in electrical contact with the second emitter resistor.

Example 10 includes the micro-ion pump of any of Examples 1-9, wherein the plurality of thin-film-edge field emitters have a width having an extent in the Z direction of a first Y-Z plane and the plurality of thin-film-edge field emitters have a thickness having an extent in the Y direction of the first Y-Z plane, wherein the width is at least 10 times the thickness.

Example 11 includes the micro-ion pump of Example 10, wherein the width WE is within a range of two to twenty microns and the thickness is within a range of ten nanometers to thirty nanometers.

Example 12 includes the micro-ion pump of any of Examples 1-11, wherein the second gate electrode is offset from the high voltage anode by a vacuum gap.

Example 13 includes a method for forming a micro-ion pump, the method comprising: forming a first gate electrode on a surface of a substrate in an X-Z plane; forming a first insulating layer on the first gate electrode; patterning a plurality of thin-film-edge field emitters on the first insulating layer, wherein first endfaces of a first portion of the plurality of thin-film-edge field emitters are in a first Y-Z plane, and wherein second endfaces of a second portion of the plurality of thin-film-edge field emitters are in a second Y-Z plane; forming a second insulating layer over the patterned thin-film-edge field emitters and the exposed insulating layer; forming a second gate electrode over the second insulating layer; and etching an opening through the second gate electrode, the second insulating layer, the first insulating layer, and the first gate electrode, wherein the first endfaces extend from the first portion and the second portion of the insulating layer, and wherein the second endfaces extend from the first portion and the second portion of the insulating layer.

Example 14 includes the method of Example 13, wherein etching the opening comprises: etching the opening having a width in the X direction that is less than a distance between the first Y-Z plane and the second Y-Z plane.

Example 15 includes the method of any of Examples 13-14, further comprising: patterning a first back-connector in contact with the first portion of the plurality of thin-film-edge field emitters; patterning a second back-connector in contact with the second portion of the plurality of thin-film-edge field emitters; patterning a first emitter resistor in contact with the first back connector; and patterning a second emitter resistor in contact with the second back connector, wherein forming the second insulating layer over the patterned thin-film-edge field emitters comprises: forming the second insulating layer over the patterned thin-film-edge field emitters, the first back-connector, the second back-connector, the first emitter resistor, the second emitter resistor, and the exposed insulating layer.

Example 16 includes the method of Example 15, further comprising: patterning a first contact pad in contact with the first emitter resistor; and patterning a second contact pad in contact with the second emitter resistor.

Example 17 includes the method of any of Examples 13-16, further comprising: positioning a high voltage anode in a plane parallel to and offset from the surface of the substrate, wherein the second gate electrode is between the plurality of thin-film-edge field emitters and the high voltage anode; and coupling a circuit to the high voltage anode, the first gate electrode, the second gate electrode, and the plurality of thin-film-edge field emitters, the circuit configurable to operably apply a voltage potential difference between the high voltage anode and the first gate electrode, the second gate electrode, and the plurality of thin-film-edge field emitters.

Example 18 includes a high-vacuum-micro-electro-mechanical system (MEMS) including: a housing to enclose a micro-ion pump; and the micro-ion pump, the micro-ion pump including: a plurality of thin-film-edge field emitters in a first X-Z plane, wherein the thin-film-edge field emitters have a respective plurality of high aspect ratio endfaces in at least one Y-Z plane, and wherein a plurality of main bodies of the respective plurality of thin-film-edge field emitters in the first X-Z plane is encased by an insulating layer while the plurality of high aspect ratio endfaces extend from the insulating layer; a first gate electrode in a second X-Z plane offset from the first X-Z plane by a first portion of the insulating layer; a second gate electrode in a third X-Z plane offset from the first X-Z plane by a second portion of the insulating layer; and a high voltage anode in a fourth X-Z plane offset from the plurality of thin-film-edge field emitters in the first X-Z plane, wherein the second gate electrode is between the high voltage anode and the plurality of thin-film-edge field emitters.

Example 19 includes the high-vacuum-micro-electro-mechanical system of Example 18, wherein the plurality of thin-film-edge field emitters include: a first portion of the plurality of thin-film-edge field emitters having a plurality of first endfaces in a first Y-Z plane, and a second portion of the plurality of thin-film-edge field emitters having a plurality of second endfaces in a second Y-Z plane, wherein an opening in the second gate electrode has a width in the X direction that is less than the difference between the first Y-Z plane and the second Y-Z plane, wherein the plurality of high aspect ratio first endfaces and the plurality of high aspect second endfaces are protected from high energy ions by the second gate electrode.

Example 20 includes the high-vacuum-micro-electro-mechanical system of Example 19, further comprising: a back-connector in electrical contact with at least two of the plurality of thin-film-edge field emitters; and an emitter resistor in electrical contact with the back-connector.

Although specific embodiments have been illustrated and described herein, it will be appreciated by those of ordinary skill in the art that any arrangement, which is calculated to achieve the same purpose, may be substituted for the specific embodiments shown. Therefore, it is manifestly intended that this invention be limited only by the claims and the equivalents thereof.

## Claims

1. A micro-ion pump (10), comprising:
a plurality of thin-film-edge field emitters (100(1-8)) in a first X-Z plane (X₁, Z₁), wherein the plurality of thin-film-edge field emitters have a respective plurality of end faces (101(1-8)) with a high aspect ratio in at least one Y-Z plane (Y'₁, Z'₁);
a first gate electrode (115) in a second X-Z plane (X₂, Z₂) offset from the first X-Z plane;
a second gate electrode (110) positioned in a third X-Z plane (X₃, Z₃) offset from the first X-Z plane; and
a high voltage anode (150) in a fourth X-Z plane offset from the plurality of thin-film-edge field emitters in the first X-Z plane, wherein the second gate electrode is between the high voltage anode and the plurality of thin-film-edge field emitters.

2. The micro-ion pump (10) of claim 1, further comprising an insulating layer (180), the insulating layer including a first portion (180-1) and a second portion (180-2),
wherein the first gate electrode (115) in the second X-Z plane is offset from the plurality of thin-film-edge field emitters (100(1-8)) in the first X-Z plane by the first portion of the insulating layer, and
wherein the second gate electrode (110) in the third X-Z plane is offset from the plurality of thin-film-edge field emitters in the first X-Z plane by the second portion of the insulating layer,
wherein a plurality of main bodies (102(1-8)) of the respective plurality of thin-film-edge field emitters in the first X-Z plane is encased by the first portion and the second portion of the insulating layer while the plurality of high aspect ratio end faces (101(1-8)) of the plurality of thin-film-edge field emitters extend from the first portion and the second portion of the insulating layer.

3. The micro-ion pump (10) of claim 2, wherein the plurality of thin-film-edge field emitters (100(1-8)) include:
a first portion (100(1-4)) of the plurality of thin-film-edge field emitters having a plurality of first end faces (101(1-8)) in a first Y-Z plane (Y'₁, Z'₁); and
a second portion (100(5-8)) of the plurality of thin-film-edge field emitters having a plurality of second end faces (101(1-8)) in a second Y-Z plane (Y'₂, Z'₂),
wherein an opening (160) in the second gate electrode (110) has a width (Wₒ) in the X direction that is less than the distance (D_{EF}) between the first Y-Z plane and the second Y-Z plane, wherein the plurality of high aspect ratio first end faces (101(1-4)) and the plurality of high aspect second end faces (101(1-8)) are protected from high energy ions (i⁺) by the second gate electrode (110).

4. The micro-ion pump (10) of claim 1, wherein the second gate electrode (110) is formed from a chemically active material.

5. The micro-ion pump (10) of claim 1, the second gate electrode (110) is formed from at least one of: Tantalum and Titanium.

6. The micro-ion pump (10) of claim 1, further comprising:
a back-connector (105) in electrical contact with at least two of the plurality of thin-film-edge field emitters (100(1-8)); and
an emitter resistor (106) in electrical contact with the back-connector.

7. The micro-ion pump (10) of claim 6, further comprising a contact pad (107) in electrical contact with the emitter resistor (106).

8. The micro-ion pump (10) of claim 1, further comprising:
a first back-connector (105-1) in electrical contact with a first portion 100(1-4) of the plurality of thin-film-edge field emitters (100(1-8));
a first emitter resistor (106-1) in electrical contact with the first back-connector;
a second back-connector (105-2) in electrical contact with a second portion 100(5-8) of the plurality of thin-film-edge field emitters; and
a second emitter resistor (106-2) in electrical contact with the second back-connector.

9. The micro-ion pump (10) of claim 1, wherein the plurality of thin-film-edge field emitters (100(1-8)) have a width (W_{E}) having an extent in the Z direction of a first Y-Z plane (Y'₁, Z'₁) and the plurality of thin-fihn-edge field emitters have a thickness (T_{E}) having an extent in the Y direction of the first Y-Z plane, wherein the width is at least 10 times the thickness.

10. A high-vacuum- micro-electro-mechanical system (MEMS) (12) including:
a housing (300) to enclose a micro-ion pump (10); and
the micro-ion pump, the micro-ion pump including:
a plurality of thin-film-edge field emitters (100(1-8)) in a first X-Z plane (X₁, Z₁), wherein the plurality of thin-film-edge field emitters have a respective plurality of end faces (101(1-8)) with a high aspect ratio in at least one Y-Z plane (Y'₁, Z'₁);
a first gate electrode (115) in a second X-Z plane (X₂, Z₂) offset from the first X-Z plane;
a second gate electrode (110) positioned in a third X-Z plane (X₃, Z₃) offset from the first X-Z plane; and
a high voltage anode (150) in a fourth X-Z plane offset from the plurality of thin-film-edge field emitters in the first X-Z plane, wherein the second gate electrode is between the high voltage anode and the plurality of thin-film-edge field emitters.
